# EUROPÄISCHE PATENTANMELDUNG

(11) **EP 2 733 234 A2**
(43) Veröffentlichungstag der Anmeldung: **21.05.2014**
(21) Anmeldenummer: 13005168.3
(22) Anmeldetag: 31.10.2013
(51) Int. Cl.: C23C 14/24

(54) **Verdampferzelle, Beschichtungsvorrichtung und Verfahren zur Verdampfung eines Verdampfungsmaterials**

(30) Priorität: 19.11.2012 DE 102012022619
(71) Anmelder: CreaTec Fischer & Co. GmbH, 74391 Erligheim (DE)
(72) Erfinder: Braun, Wolfgang, 74321 Bietigheim-Bissingen (DE)
(74) Vertreter: Hertz, Oliver

(57) **Zusammenfassung**

Eine Verdampferzelle (100) umfasst einen ersten Tiegel (10) mit einer Tiegelwand (11), wobei der erste Tiegel (10) zur Aufnahme von Verdampfungsmaterial und zur Verdampfung des Verdampfungsmaterials eingerichtet ist und die Tiegelwand (12) durchgehende Hohlräume (14) aufweist. Es werden auch eine Beschichtungsvorrichtung (200), die mit mindestens einer derartigen Verdampferzelle (100) ausgestattet ist, und ein Verfahren zur Verdampfung eines Verdampfungsmaterial beschrieben.

## Beschreibung

Die Erfindung betrifft eine Verdampferzelle, die zur Verdampfung eines Verdampfungsmaterials, z. B. für die Beschichtung eines Substrats, eingerichtet ist und einen heizbaren Tiegel zur Aufnahme des Verdampfungsmaterials aufweist. Die Erfindung betrifft des Weiteren eine Beschichtungsvorrichtung, die mit mindestens einer derartigen Verdampferzelle ausgestattet ist. Die Erfindung betrifft auch ein Verfahren zur Verdampfung des Verdampfungsmaterials, wobei eine Verdampferzelle der genannten Art verwendet wird. Anwendungen der Erfindung sind bei der Überführung von festen oder flüssigen Materialien in den gas- oder dampfförmigen Zustand (hier als Dampfphase bezeichnet), z. B. für Beschichtungszwecke, gegeben.

Es ,ist allgemein bekannt, für die thermische Verdampfung in Vakuum oder Ultrahochvakuum Verdampferzellen, insbesondere Effusionszellen, zu verwenden, in denen das zu verdampfende Material (Quellmaterial, Verdampfungsmaterial) in einem Tiegel gehalten wird. Im praktischen Betrieb treten am Tiegel erhebliche Temperaturwechsel auf, beispielsweise bei der Erwärmung auf eine vorbestimmte Betriebstemperatur der Verdampferzelle oder bei deren Abkühlung auf eine Standby-Temperatur. Die Temperaturwechsel verursachen bei herkömmlichen Verdampferzellen Probleme, weil das Tiegelmaterial und das Verdampfungsmaterial typischerweise verschiedene thermische Ausdehnungskoeffizienten aufweisen. Beispielsweise kann das Verdampfungsmaterial sich beim Aufheizen stärker ausdehnen als der Tiegel und diesen sprengen, oder das Verdampfungsmaterial kann sich bei hohen Temperaturen im Tiegel verkeilen und diesen beim Abkühlen sprengen, wenn sich das Verdampfungsmaterial langsamer zusammenzieht als der Tiegel. Diese Probleme sind bei Verdampfungsmaterialen, die aus dem flüssigen Zustand verdampft werden, die also bei der Betriebstemperatur der Verdampferzelle flüssig sind, während sie bei der Standby-Temperatur fest sind, besonders ausgeprägt.

Aufgrund der genannten Probleme kann es bei herkömmlichen Tiegeln zu substantiellen Beschädigungen kommen. Beispielsweise kann der Tiegel gesprengt werden, so dass das Verdampfungsmaterial aus der Verdampferzelle ausfließen oder herausrieseln und diese durch Korrosion oder Kurzschluss einer Widerstandsheizung zerstören kann. Die genannten Probleme werden noch verstärkt, wenn das Tiegelmaterial in Bezug auf das Verdampfungsmaterial nicht inert ist, sondern beide Materialien miteinander reagieren können.

Aus der Praxis sind verschiedene Ansätze bekannt, die beschriebenen Probleme zu vermeiden. Beispielsweise kann der Tiegel in Abhängigkeit vom Verdampfungsmaterial so gewählt werden, dass die Tiegel- und Verdampfungsmaterialien die gleichen thermischen Ausdehnungskoeffizienten aufweisen. Diese Auswahl stellt jedoch in der Praxis eine starke Einschränkung dar, da nicht für alle interessierenden Verdampfungsmaterialien, deren thermische Ausdehnungskoeffizienten ein breites Intervall abdecken können, geeignete Tiegelmaterialien zur Verfügung stehen. Als Alternative wird in WO 2011/060905 A2 für die thermische Verdampfung von Silizium vorgeschlagen, die Dicke der Tiegelwand und den Innendurchmesser des Tiegels zu optimieren, um einen Tiegelbruch aufgrund des genannten Temperaturwechsels zu vermeiden. Dieser Ansatz kann jedoch auch von Nachteil sein, wenn er auf bestimmte Materialien beschränkt ist.

Die Aufgabe der Erfindung ist es, eine verbesserte Verdampferzelle bereitzustellen, mit der Nachteile herkömmlicher Techniken vermieden werden und die insbesondere eine erhöhte Zuverlässigkeit bei wiederholten Temperaturwechseln und/oder einen größeren Anwendungsbereich aufweist. Die Aufgabe der Erfindung ist es auch, eine mit einer derartigen Verdampferzelle ausgestattete Beschichtungsvorrichtung und ein Verfahren zur Verdampfung von Verdampfungsmaterial unter Verwendung der Verdampferzelle bereitzustellen, mit denen Nachteile herkömmlicher Techniken vermieden werden.

Diese Aufgaben werden durch eine Verdampferzelle, durch eine Beschichtungsvorrichtung und/oder ein Verdampfungsverfahren mit den Merkmalen der unabhängigen Ansprüche gelöst. Vorteilhafte Ausführungsformen und Anwendungen der Erfindung ergeben sich aus den abhängigen Ansprüchen.

Gemäß einem ersten Gesichtspunkt der Erfindung wird eine Verdampferzelle bereitgestellt, die einen Tiegel (im Folgenden: erster Tiegel) mit einer Tiegelwand und einer Austrittsöffnung aufweist. Der erste Tiegel hat einen freien Innenraum, der eine Aufnahme für das Verdampfungsmaterial bildet. Der Innenraum wird außer an der Austrittsöffnung von der Tiegelwand begrenzt. Typischerweise hat der erste Tiegel eine längliche Gestalt, die sich in einer axialen Richtung des ersten Tiegels erstreckt und deren Enden durch die Austrittsöffnung und einen Tiegelboden gebildet werden. Bei Erwärmung des Tiegels mit einer Heizeinrichtung auf eine vorbestimmte Betriebstemperatur wird das Verdampfungsmaterial in die Dampfphase überführt und durch die Austrittsöffnung in die Umgebung, z. B. hin zu einem Substrat, abgegeben. Gemäß der Erfindung weist die Tiegelwand durchgehende Hohlräume (Löcher, Lücken) auf. Das Wandmaterial der Tiegelwand ist nicht dicht geschlossen, sondern für das Verdampfungsmaterial, insbesondere im flüssigen Zustand oder in der Dampfphase aufnahmefähig und/oder insbesondere in der Dampfphase durchlässig. Der erste Tiegel ist angepasst, dass das Verdampfungsmaterial nicht nur im gas- oder dampfförmigen Zustand durch die Austrittsöffnung abgegeben, sondern auch in und/oder durch die Tiegelwand transportiert werden kann. Die Hohlräume sind so bemessen, dass bei Gebrauch der Verdampferzelle, insbesondere bei der Betriebstemperatur, das Verdampfungsmaterial im ersten Tiegel gehalten wird und nicht aus dem ersten Tiegel rieselt oder tropft.

Die Tiegelwand mit den Hohlräumen bietet den Vorteil, dass die oben beschriebenen Probleme durch betriebsbedingte Temperaturwechsel vermieden werden. Untersuchungen des Erfinders haben ergeben, dass die erfindungsgemäß aufnahmefähige und/oder durchlässige Tiegelwand eine erhöhte mechanische Haltbarkeit aufweist, ohne dass kritische Beeinträchtigungen durch einen unerwünschten Austritt von Verdampfungsmaterial auf eine Außenseite der Tiegelwand entstehen. Bei speziellen Ausführungsformen der Erfindung kann der Austritt von Verdampfungsmaterial auf eine Außenseite der Tiegelwand vorgesehen sein, ohne dass die Funktion der Verdampferzelle beeinträchtigt wird. Die Hohlräume in der Tiegelwand erlauben, dass bei Gebrauch der Verdampferzelle eine in der Tiegelwand Materialzusammensetzung gebildet wird, die eine im Vergleich zum reinen Wandmaterial des Tiegels erhöhte Beständigkeit bei Temperaturwechseln aufweist. Der erste Tiegel weist eine Nachgiebigkeit auf, die eine Deformation des ersten Tiegels ohne eine Beschädigung ermöglicht. Es wurde festgestellt, dass die Materialzusammensetzung keine Vermengung der Materialien auf atomarer Ebene oder im sub-nm-Bereich aufweisen muss, um die mit der Erfindung angestrebten Vorteile zu erreichen. Vielmehr können Hohlräume charakteristische Dimensionen nicht nur im sub-nm-Bereich, sondern alternativ oder zusätzlich im nm-, pm- und/oder mm-Bereich aufweisen. Des Weiteren wurde festgestellt, dass die verbesserte mechanische Beständigkeit und damit erhöhte Betriebssicherheit und Funktionsdauer der Verdampferzelle nicht auf bestimmte Materialien beschränkt ist. Vielmehr könnten unter praktischen Bedingungen getestete Verdampferzellen gemäß der Erfindung mit einer Vielzahl verschiedener Wand- und Verdampfungsmaterialien mechanisch stabil bleiben. Die Verdampfungsmaterialien können bei Raumtemperatur und bei der Betriebstemperatur in flüssiger oder fester Form vorliegen. Geeignete Verdampfungsmaterialien sind z. B. Silizium, Aluminium oder Germanium.

Mit dem Begriff "durchgehende Hohlräume" wird die Tiegelwand des ersten Tiegels so charakterisiert, dass im Aufbau der Tiegelwand Unterbrechungen vorhanden sind, die vom Innenraum des ersten Tiegels bis hin zu dessen Außenseite verlaufen. Die Hohlräume können aufgrund von der Struktur (z.B. Porosität, Materialtextur), von geometrischen Eigenschaften (Dicke) der Tiegelwand, von dem makroskopischen Aufbau (z.B. Mehrlagigkeit der Tiegelwand) und/oder von Charakteristika des Verfahren zur Herstellung der Tiegelwand vorhanden sein. Beispielsweise können die Hohlräume in der Tiegelwand bereits vor der ersten Benutzung der Verdampferzelle als inhärente Wandeigenschaft gegeben sein. Alternativ ist es möglich, das Wandmaterial der Tiegelwand so herzustellen, dass die Hohlräume erst bei Verwendung der Verdampferzelle durch die Wechselwirkung des Wandmaterials mit dem Verdampfungsmaterial bei Temperaturwechseln des ersten Tiegels gebildet werden. Beispielsweise kann die Tiegelwand durch mindestens einen Temperaturzyklus zwischen Betriebs- und Standby-Temperatur mechanisch so beansprucht werden, dass sie nicht wie bei herkömmlichen Verdampferzellen unerwünschte Brüche aufweist, sondern in der Tiegelwand die Hohlräume, wie z. B. Risse, gebildet werden. Die Hohlräume können in der gesamten Tiegelwand, einschließlich der umlaufenden Seitenwand und des Tiegelbodens, vorhanden sein. Alternativ können die Hohlräume in Abschnitten der Tiegelwand, z. B. ausschließlich in der Seitenwand oder Teilbereichen von dieser und nicht im Tiegelboden, vorhanden sein.

Gemäß einem zweiten allgemeinen Gesichtspunkt der Erfindung wird eine Beschichtungsvorrichtung bereitgestellt, die mit mindestens einer Verdampferzelle gemäß dem oben genannten ersten Gesichtspunkt der Erfindung ausgestattet ist. Aufgrund der erhöhten mechanischen Beständigkeit der Verdampferzelle hat die Beschichtungsvorrichtung den Vorteil eines verlängerten störungsfreien Betriebs bzw. verlängerter Wartungsintervalle.

Gemäß einem dritten allgemeinen Gesichtspunkt der Erfindung wird ein Verfahren zur Verdampfung eines Verdampfungsmaterials, insbesondere zur Beschichtung eines Substrats mit dem Verdampfungsmaterial bereitgestellt, bei dem die Verdampferzelle gemäß dem ersten Gesichtspunkt der Erfindung verwendet wird. Bei dem erfindungsgemäßen Verfahren ist vorgesehen, das Verdampfungsmaterial in dem ersten Tiegel anzuordnen und den ersten Tiegel auf eine vorbestimmte Betriebstemperatur zu heizen, um die Dampfphase des Verdampfungsmaterials (Verdampfungsmaterial im gas- oder dampfförmigen Zustand) zu erzeugen. Erfindungsgemäß weist die Tiegelwand des ersten Tiegels der Verdampferzelle die durchgehenden Hohlräume auf, in welche die Dampfphase des Verdampfungsmaterials eintritt. Vorteilhafterweise werden die Hohlräume mit dem Verdampfungsmaterial gefüllt. Typischerweise werden die zwischen dem Innenraum und der Außenseite des ersten Tiegels bestehenden Unterbrechungen durch das Verdampfungsmaterial ganz oder zumindest teilweise geschlossen. Entgegen der Erwartung tritt kein oder nur vernachlässigbar wenig Verdampfungsmaterial zur Außenseite der Tiegelwand durch. Der Austritt von Verdampfungsmaterial in die Umgebung des ersten Tiegels durch die Tiegelwand ist zumindest teilweise blockiert. Wenn in Abhängigkeit von den verwendeten Materialien und Betriebsbedingungen Verdampfungsmaterial austritt, kann dies gemäß den unten beschrieben Ausführungsformen der Erfindung mit der Dampfphase des Verdampfungsmaterials, die aus der Austrittsöffnung des ersten Tiegels austritt, zusammengeführt und z.B. auf einem Substrat abgeschieden werden.

Vorteilhafterweise sind eine Vielzahl von Möglichkeiten verfügbar, die Tiegelwand mit den Hohlräumen bereitzustellen. Beispielsweise sind verschiedene Varianten der Form der Hohlräume möglich, die einzeln oder in Kombination realisiert sein können. Die Hohlräume umfassen vorzugsweise Poren, Risse, Kanäle und/oder Schlitze in der Tiegelwand. Poren sind im Wandmaterial verteilte, miteinander verbundene Höhlungen (offenporige Wandstruktur), die beispielsweise durch die Herstellung des Wandmaterials, wie z.B. in einer porösen Keramik gegeben sind. Risse sind Unterbrechungen im Wandmaterial, die typischerweise im Gebrauch der Verdampferzelle gebildet werden. Durch mechanische Beanspruchungen bei Temperaturwechseln werden in der Tiegelwand Spalte gebildet, welche die für Dampfphase des Verdampfungsmaterials durchlässig sind, ohne die mechanische Stabilität des ersten Tiegels zu beeinträchtigen. Kanäle sind in radialer Richtung zwischen dem Innenraum des ersten Tiegels und seiner Außenseite verlaufende Leitungen durch die Tiegelwand. Schlitze in der Tiegelwand sind typischerweise in der axialen Richtung des ersten Tiegels ausgerichtete, bei der Herstellung der Tiegelwand geformte, gerade oder gekrümmte Spalte.

Die Hohlräume in der Tiegelwand weisen eine charakteristische Dimension (Größe) in azimuthaler und/oder axialer Richtung auf, die vorzugsweise kleiner als 1 mm, besonders bevorzugt kleiner als 500 µm, insbesondere kleiner als 100 µm, wie z.B. 10 µm, 1 µm oder weniger bis unterhalb von 500 nm oder 200 nm, beträgt. Die konkrete Dimensionierung der Hohlräume kann vom Fachmann in Abhängigkeit von den verwendeten Materialien der Tiegelwand und des Verdampfungsmaterials gewählt werden. Dabei kann er auf Tabellenwerte, insbesondere der Oberflächenspannung, und einfache Tests zurückgreifen.

Besonders bevorzugt wird die charakteristische Dimension der Hohlräume so gewählt, dass geschmolzenes Verdampfungsmaterial unter der Wirkung der Oberflächenspannung in den Hohlräumen gehalten wird. Das Material der Tiegelwand und die Dimension der Hohlräume wird so gewählt, dass bei der Betriebstemperatur der Verdampferzelle die Oberflächenspannung den Druck des geschmolzenen Verdampfungsmaterials gemäß der Füllhöhe im ersten Tiegel mindestens kompensiert. Die Hohlräume können gleiche oder verschiedene Größen aufweisen. Beispielsweise kann vom Tiegelboden ausgehend ein Gradient mit wachsenden Größen vorgesehen sein. Die in axialer Richtung untersten Hohlräume sind am kleinsten, um im Vergleich zu oberen Hohlräumen einen höheren Druck flüssigen Verdampfungsmaterials nahe dem Tiegelboden auszugleichen.

Wenn die Hohlräume Schlitze in der Tiegelwand umfassen, so können diese gemäß einer weiteren bevorzugten Ausführungsform der Erfindung in axialer und/oder in radialer Richtung der Tiegelwand relativ zueinander versetzt angeordnet sein. Bei Versetzung in axialer Richtung hat die Tiegelwand die Struktur eines Streckmetalls. Benachbarte Schlitze sind in axialer Richtung jeweils um eine halbe Periode versetzt angeordnet. Bei Verwendung der Verdampferzelle mit Temperaturwechseln kann die Tiegelwand gedehnt werden, so dass ein Streckgitter gebildet wird. Die Versetzung in radialer Richtung kann bei einer mehrlagigen Tiegelwand derart realisiert sein, dass Schlitze in einer Lage durch das Wandmaterial einer benachbarten Lage abgedeckt werden. Durchgehende Unterbrechungen vom Innenraum des ersten Tiegels zu seiner Außenseite verlaufen durch die Schlitze in radialer Richtung und durch Spalte zwischen den Lagen der Tiegelwand in azimuthaler Richtung.

Gemäß weiteren Varianten der Erfindung können die Hohlräume in der Tiegelwand oder deren Teilen regelmäßig und/oder unregelmäßig verteilt angeordnet sein. Eine regelmäßige Verteilung umfasst z.B. eine periodische Anordnung der Hohlräume in der Tiegelwand, gegebenenfalls einschließlich des Tiegelbodens. Eine unregelmäßige Verteilung kann gewählt werden, um beispielsweise in Bereichen erhöhter Heizung eine höhere Dichte der Hohlräume und/oder in der Nähe der Austrittsöffnung des Tiegels keine Hohlräume bereitzustellen.

Vorteilhafterweise kann die Tiegelwand einlagig oder mehrlagig gebildet sein. Eine einlagige Tiegelwand umfasst eine einzige Schicht des Wandmaterials, wie z. B. eine einzige Metallfolie, in der die Hohlräume gebildet sind. Eine mehrlagige Tiegelwand ist aus zwei oder mehr Schichten von einem einzigen oder mehreren Wandmaterialien zusammengesetzt, in denen die Hohlräume gebildet sind. Gemäß besonders bevorzugten Ausführungsformen der Erfindung umfasst die Tiegelwand eine oder mehrere Lagen eines Drahtgeflechts, eine oder mehrere Lagen einer mit Schlitzen versehenen Folie, eine oder mehrere Schichten eines Sintermaterials und/oder eine oder mehrere Schichten eines offenporigen Schaums. Diese Materialien haben sich in der Praxis als besonders beständig selbst bei starken Temperaturwechseln, insbesondere bei Betriebstemperaturen bis zu 2500 °C, erwiesen.

Gemäß einer weiteren bevorzugten Ausführungsform der Erfindung umfasst die Verdampferzelle den ersten Tiegel und einen zweiten Tiegel, in dem der erste Tiegel angeordnet ist. Der zweite Tiegel wird durch eine Tiegelwand (einschließlich einem Tiegelboden) mit einer Tiegelöffnung gebildet. Typischerweise hat auch der zweite Tiegel eine längliche Gestalt. Der erste Tiegel ist im Innenraum des zweiten Tiegels angeordnet. Vorzugsweise ist zwischen dem ersten und dem zweiten Tiegel eine Lücke gebildet, die vorteilhafterweise mehrere Funktionen erfüllen kann. Erstens ermöglicht die Lücke mechanische Deformationen des ersten Tiegels oder eine Auswirkung auf den zweiten Tiegel. Die Lücke bietet einen Spielraum zur Aufnahme einer durch Temperaturwechsel bedingten Deformation des ersten Tiegels. Zweitens kann durch die Lücke die Dampfphase des Verdampfungsmaterials, die durch die Tiegelwand des ersten Tiegels zu dessen Außenseite hin ausgetreten ist, zur Austrittsöffnung des zweiten Tiegels und von dort gemeinsam mit der Dampfphase des Verdampfungsmaterials aus dem ersten Tiegel abgegeben werden, z. B. um auf einem Substrat eine Schicht zu bilden.

Die Ausführungsform der erfindungsgemäßen Verdampferzelle mit dem ersten und dem zweiten Tiegel (Doppeltiegel) bietet besondere Vorteile für einen zuverlässigen Betrieb der Verdampferzelle. Typischerweise wird die Verdampferzelle mit einer Heizeinrichtung geheizt, die in einer Umgebung des zweiten Tiegels angeordnet ist. Die Heizeinrichtung, die z. B. eine Widerstandsheizung und/oder eine Elektronstrahlheizung umfasst, heizt den zweiten Tiegel von außen auf. Mit dem zweiten Tiegel wird dann der innere, erste Tiegel und das in diesem befindliche Verdampfungsmaterial geheizt. Aufgrund von Wärmestrahlung und Wärmeleitung ist die Temperatur des ersten Tiegels geringfügig niedriger als die Temperatur des zweiten Tiegels, jedoch ausreichend hoch, um das Verdampfungsmaterial in die Dampfphase zu überführen. Wenn im Heizbetrieb die Dampfphase durch die Tiegelwand in den zweiten Tiegel austritt, so kann das Verdampfungsmaterial aufgrund der höheren Temperatur im zweiten Tiegel nicht mehr kondensieren, sondern ausschließlich durch die Lücke und die Austrittsöffnung des zweiten Tiegels in die Umgebung austreten. Eventuelle Belastungen des zweiten Tiegels bei Temperaturwechseln oder durch eine Wechselwirkung mit dem Verdampfungsmaterial werden ausgeschlossen. Entsprechend wird auch ein unbeabsichtigter Austritt des Verdampfungsmaterials, z. B. hin zur Heizeinrichtung oder zu anderen Teilen der Beschichtungsvorrichtung ausgeschlossen.

Wenn gemäß einer weiteren Ausführungsform der Erfindung der erste Tiegel von dem zweiten Tiegel lösbar angeordnet ist, ergibt sich vorteilhafterweise eine Austauschbarkeit des ersten Tiegels. Die Verdampferzelle kann besonders einfach an die Verdampfung verschiedener Verdampfungsmaterialien angepasst werden. Des Weiteren kann, falls nach längerem Gebrauch eine Beschädigung des ersten Tiegels auftritt, die Verdampferzelle durch Austausch des ersten Tiegels leicht regeneriert werden.

Vorteilhafterweise bestehen des Weiteren verschiedene Möglichkeiten, das Material und/oder die Geometrie des ersten und/oder des zweiten Tiegels auszuwählen. Die Tiegel können vorzugsweise aus Metall, z.B. Wolfram oder Tantal, oder Keramik, z.B. Bornitrid hergestellt sein. Die Tiegel können die gleiche oder verschiedene geometrische Formen aufweisen, wobei vorzugsweise eine zylindrische und/oder eine konische Form gewählt wird.

Weitere Vorteile und Einzelheiten der Erfindung werden im Folgenden unter Bezug auf die beigefügten Zeichnungen beschrieben. Es zeigen:
- Figur 1:: eine schematische Schnittansicht einer ersten Ausführungsform der erfindungsgemäßen Verdampferzellen;
- Figur 2:: eine schematische Schnittansicht einer Ausführungsform der erfindungsgemäßen Beschichtungsvorrichtung;
- Figur 3:: schematische Illustrationen der Tiegelwand des ersten Tiegels bei weiteren Ausführungsformen der erfindungsgemäßen Verdampferzelle;
- Figur 4:: eine weitere Ausführungsform der Erfindung, bei welcher der erste Tiegel aus einem Drahtgeflecht hergestellt ist; und
- Figur 5:: eine weitere Ausführungsform der Erfindung, bei welcher der erste Tiegel aus einer geschlitzten Folie hergestellt ist.

Ausführungsformen der Erfindung werden im Folgenden unter beispielhaftem Bezug auf Verdampferzellen mit zylinderförmigen oder konischen Tiegeln beschrieben. Es wird betont, dass die Umsetzung der Erfindung nicht auf diese Formen beschränkt, sondern entsprechend mit anderen Tiegelformen möglich ist. Des Weiteren wird die Erfindung insbesondere in Bezug auf die Gestaltung des ersten Tiegels und seiner Anordnung im zweiten Tiegel beschrieben. Die Umsetzung der Erfindung ist nicht auf die Ausführungsform mit zwei Tiegeln beschränkt, sondern entsprechend auch mit einer Verdampferzelle möglich, die als einzigen Tiegel den ersten Tiegel mit den durchgehenden Hohlräumen in der Tiegelwand aufweist. Einzelheiten von Verdampferzellen und deren Gebrauch, insbesondere in Beschichtungsvorrichtungen, wie z. B. Einzelheiten der Vakuumerzeugung, der Heizung, der Steuerung der Verdampfung und der Substratpräparation und -handhabung werden im Folgenden nicht beschrieben, da sie an sich aus dem Stand der Technik bekannt sind.

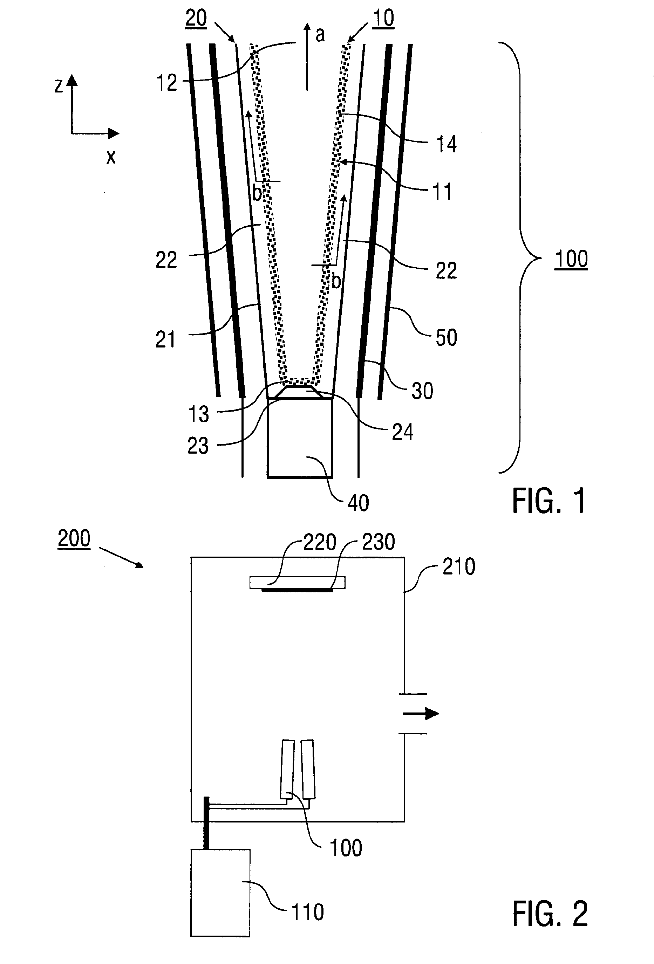

Figur 1 zeigt eine schematische Schnittansicht einer ersten Ausführungsform der erfindungsgemäßen Verdampferzelle 100 mit einem ersten Tiegel 10, einem zweiten Tiegel 20, einer Heizeinrichtung 30, einer Halteeinrichtung 40 und einer Abschirmeinrichtung 50. Diese koaxial angeordneten Komponenten sind in einer Beschichtungsvorrichtung mit einer Energieversorgung und einer Steuereinrichtung (siehe Figur 2) verbunden, wie es an sich von herkömmlichen Verdampferzellen bekannt ist.

Der erste Tiegel 10 umfasst eine Tiegelwand 11 mit einer konischen Form, die sich in einer Längsrichtung (axiale Richtung, z-Richtung in Figur 1) erstreckt und durchgehende Hohlräume 14, z. B. Poren aufweist. Am ersten (oberen) Ende des ersten Tiegels 10, an dem die konische Form den größten Tiegeldurchmesser bildet, ist eine Austrittsöffnung 12 vorgesehen, durch welche die Dampfphase des Verdampfungsmaterials in die Umgebung, z. B. zu einem Substrat (nicht dargestellt) austreten kann. Am entgegengesetzten (zweiten) Ende des Tiegels 10 ist dieser mit dem Tiegelboden 13 geschlossen. Der Tiegel 10 hat z. B. einen Innendurchmesser im Bereich von 4 mm bis 12 mm am Tiegelboden 13 und 4 mm bis 25 mm an der Austrittsöffnung 12 sowie eine axiale Länge von 10 cm. An der Austrittsöffnung 12 können zusätzliche Komponenten, wie z.B. eine Blende vorgesehen sein. Die Tiegelwand 11 ist aus einem mit den Hohlräumen 14 versehenen Wandmaterial, z. B. aus einer Wolfram-Metallfolie mit einer Dicke von 100 µm und einer typischen Porengröße von 0,1 mm hergestellt.

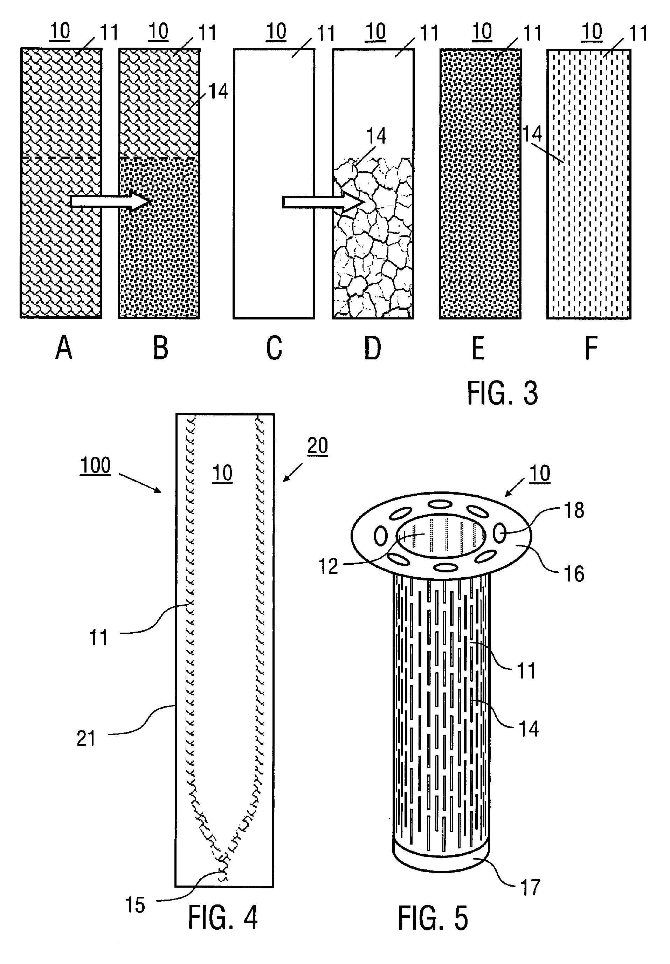

Der zweite Tiegel 20 umfasst eine Tiegelwand 21, die ebenfalls eine konische Form aufweist und aus Metall, z. B. aus Wolfram oder Tantal, oder aus einem keramischen Material, z. B. Bornitrid, hergestellt ist. Der zweite Tiegel 20 ist so dimensioniert, dass in seinem Innenraum der erste Tiegel 10 vollständig oder teilweise aufgenommen werden kann, wobei zwischen der Außenseite der Tiegelwand 11 des ersten Tiegels 10 und der Innenseite der Tiegelwand 21 des zweiten Tiegels 20 eine Lücke 22 gebildet ist. Die radiale Dicke der Lücke 22 (Abstand zwischen den Tiegelwänden 11, 21 in x-Richtung) ist z. B. im Bereich von 1 mm bis 5 mm gewählt. Am Tiegelboden 23 des zweiten Tiegels 20 ist ein Tiegelträger 24 angeordnet, der für eine Positionierung und Halterung des ersten Tiegels 10 im zweiten Tiegel 20 konfiguriert ist. Der Tiegelträger 24 kann z.B. Öffnungen aufweisen, in die Stifte am Tiegelboden 13 des ersten Tiegels 10 (nicht dargestellt) einführbar sind. Die Bereitstellung des Tiegelträgers 24 ist jedoch kein zwingendes Merkmal der Erfindung (siehe unten, Figur 3).

Die Heizeinrichtung 30 umfasst z. B. eine Widerstandsheizung und/oder eine Elektronenstrahlheizung, wie es an sich von herkömmlichen Verdampferzellen bekannt ist. Die Heizeinrichtung 30 kann z. B. ausgelegt sein, um indirekt durch Heizung des zweiten Tiegels 20 im ersten Tiegel 10 eine Betriebstemperatur von 1700 °C einzustellen.

Die Halteeinrichtung 40 und die Abschirmeinrichtung 50 sind ebenfalls gestaltet wie es an sich von herkömmlichen Verdampferzellen bekannt ist. Mit der Halteeinrichtung 40 wird ein mechanischer Träger für die ersten und zweiten Tiegel 10, 20 relativ zur Heizeinrichtung 30 geschaffen. Mit der Abschirmeinrichtung 50, die z. B. ein Abschirmblech aus Tantal umfasst, wird eine unerwünschte Abstrahlung von Wärme in die Umgebung der Verdampferzelle 100 vermieden.

Experimentelle Tests der Verdampferzelle 100 gemäß Figur 1 mit der Verdampfung von z. B. Silizium haben die folgenden Ergebnisse geliefert. Mit zunehmender Zahl von Heiz-Abkühl-Zyklen zwischen der Betriebstemperatur und Raumtemperatur wurde zwar eine Deformation des ersten Tiegels 10 beobachtet. Ein unerwünschter Bruch des Wandmaterials der Tiegelwand 11 des ersten Tiegels 10 erfolgte jedoch nicht. Die Untersuchung des Wandmaterials der Tiegelwand 11 hat ergeben, dass das Verdampfungsmaterial in die Tiegelwand 11 eindringt. Selbst wenn keine Legierung oder Reaktion zwischen dem Wandmaterial und dem Verdampfungsmaterial stattfindet, erweist sich die Zusammensetzung aus beiden Materialien als besonders beständig gegenüber den Temperaturwechseln beim Betrieb der Verdampferzelle. Die Stege aus Wandmaterial zwischen den mit Verdampfungsmaterial gefüllten Hohlräumen erweisen sich als genügend nachgiebig, so dass ein makroskopischer Bruch des ersten Tiegels 10 vermieden wird. Da die Ausdehnung der Stege in Umfangsrichtung des ersten Tiegels relativ gering ist, wird eine erhöhte Toleranz des ersten Tiegels gegenüber den Temperaturwechseln erzielt.

Des Weiteren zeigten Untersuchungen, dass geringe Anteile von Verdampfungsmaterial außerhalb der Austrittsöffnung 12 aus der Lücke 22 zwischen den Tiegeln 10, 20 in die Umgebung austreten. Es hat sich gezeigt, dass die Tiegelwand 11 des ersten Tiegels 10 das Verdampfungsmaterial, z. B. in flüssiger Form, aufnimmt und in Teilen durch die poröse Struktur in die Lücke 22 abgibt. Da der zweite Tiegel 20 bei einer geringfügig höheren Temperatur betrieben wird (Heizung von außen), kann das Verdampfungsmaterial im zweiten Tiegel 20 nicht kondensieren, so dass in diesem eine unbeabsichtigte Deformationen bei Temperaturwechseln ausgeschlossen ist.

Erfindungsgemäß wird bei Betrieb der Verdampferzelle ein Hybridmaterial des ersten Tiegels 10 mit einer selbstjustierenden Mischung aus Verdampfungsmaterial und Wandmaterial geschaffen, das optimal auf die thermische Ausdehnung der beiden Materialien im Temperaturintervall zwischen der Standby-Temperatur, z.B. Raumtemperatur und der Betriebstemperatur, z.B. 1700 °C abgestimmt ist. Verdampfungsmaterial dampft entweder durch die Austrittsöffnung 12 des ersten Tiegels 10 nach oben ab (Pfeil a), oder es wandert durch die poröse Tiegelwand 11, verdampft an deren Außenseite und wird durch die Lücke 22 zwischen den Tiegeln 10, 20 ebenfalls nach oben transportiert (Pfeil b), wo es in der selben Richtung wie das aus dem ersten Tiegel 10 direkt verdampfte Material den Doppeltiegel verlässt. Vorteilhafterweise findet sich auch beim Abkühlen der Verdampferzelle kein Verdampfungsmaterial im zweiten Tiegel 20 wieder, da sich dieser auf einer höheren Temperatur befindet.

Figur 2 zeigt schematisch eine Beschichtungsvorrichtung 200, die mit mindestens einer erfindungsgemäßen Verdampferzelle 100 ausgestattet ist. Die Verdampferzelle 100 ist in einer Vakuumkammer 210 angeordnet und mit einer Steuereinrichtung 110 verbunden. Die Vakuumkammer 210 ist mit einer Vakuumpumpe (nicht dargestellt) verbunden. Ferner können weitere Komponenten vorgesehen sein, wie sie von herkömmlichen Beschichtungsvorrichtungen für die physikalische Dampfabscheidung bekannt sind. Mit einem Abstand von der Verdampferzelle 100 ist eine Substrathalterung 220 in der Vakuumkammer 210 angeordnet. Die Substrathalterung 220 dient der Aufnahme eines Substrats 230, das beschichtet werden soll. Die Steuereinrichtung 110 enthält mindestens eine Energiequelle, insbesondere eine Stromquelle für eine Widerstandsheizung, und eine Steuereinheit zum Betrieb der Verdampferzelle 100.

Die Figuren 3A bis 3F zeigen schematisch Seitenansichten des ersten Tiegels 10 einer erfindungsgemäßen Verdampferzelle, wobei in den Figuren 3A/3B und 3C/3D zusätzlich die Wirkung des Verdampfungsmaterials bei Gebrauch der Verdampferzelle gezeigt ist.

Gemäß Figur 3A ist die Tiegelwand 11 des Tiegels 10 aus einem Drahtgeflecht, z. B. aus Wolframdraht, hergestellt. Das Drahtgeflecht ist durch Ineinanderschlingen einer Vielzahl von Drahtsträngen gebildet. Vorzugsweise ist eine diagonale Flechtung vorgesehen, bei der keiner der Stränge parallel zur axialen Richtung verläuft. Die diagonale Flechtung hat den Vorteil, dass der Durchmesser eines Drahtgeflecht-Schlauchs leicht geändert werden kann, indem er in axialer Richtung auseinander gezogen oder zusammengeschoben wird. Dabei wird eine Beanspruchung der Stränge in Längsrichtung vermieden, sondern lediglich der Winkel zwischen den Strängen geändert. Da die hierfür erforderlichen Kräfte gering sind, wird ein Bruch der Stränge vermieden und die gewünschte Formstabilität erhalten. Um die Leckrate des Tiegels 10 durch die Tiegelwand 11 zu minimieren, können mehrere Lagen des Drahtgeflechts ineinander gesteckt sein, um den Tiegel 10 zu bilden. Des Weiteren können Abschnitte des Tiegels, welche mechanisch weniger stark beansprucht werden, wie z.B. der Tiegelboden aus einem anderen Material als Drahtgeflecht, z. B. einem geschlossenen Wandmaterial, hergestellt sein.

In Figur 3A ist der Zustand des Tiegels 10 vor dem ersten Gebrauch der Verdampferzelle, d. h. vor dem ersten Heizvorgang illustriert. Der Tiegel ist bis zu einem bestimmten Füllstand, der durch die gestrichelte horizontale Linie markiert ist, mit Verdampfungsmaterial gefüllt. Durch das Aufheizen des Tiegels 10 wird dieser in einen veränderten Zustand überführt (siehe großer Pfeil), der in Figur 3B gezeigt ist. Geschmolzenes Verdampfungsmaterial füllt die im Drahtgeflecht vorhandenen Unterbrechungen (Hohlräume 14, Größe z. B. 0,3 mm) der Tiegelwand 11. Flüssiges Verdampfungsmaterial wird unter der Wirkung der Oberflächenspannung in der Tiegelwand 11 gehalten, so dass die Unterbrechungen im Drahtgeflecht geschlossen werden. Bei der Betriebstemperatur dampft die Dampfphase durch die Austrittsöffnung 12 ab (siehe Pfeil a). Gleichzeitig erfolgt eine Verdampfung auf der Außenseite des Tiegels 10, wobei dieser Anteil der Dampfphase über die Lücke 22 (in Figur B nicht dargestellt) gegenüber dem zweiten Tiegel abgeleitet wird.

Figur 3C illustriert einen ersten Tiegel 10, der zunächst aus einem massiven, geschlossenen Wandmaterial hergestellt ist. Erst bei Gebrauch der Verdampferzelle und beim Aufheizen wird die verschiedenen thermischen Ausdehnungskoeffizienten des Verdampfungsmaterials und des Wandmaterials eine Bildung von Mikrorissen induziert (siehe großer Pfeil), die schematisch in Figur 3D gezeigt sind. In einem konkret untersuchten Beispiel bestand der erste Tiegel 10 aus Wolfram-Blech und das Verdampfungsmaterial aus Silizium. Bei geeigneter Dimensionierung des ersten Tiegels 10 wird die Rissbildung so induziert, dass bei zyklischen Temperaturwechseln eine gegebenenfalls deformierte Gleichgewichtsform gefunden wird, die ungeachtet der Risse 14 im Wandmaterial mechanisch beständig, stabil und dicht gegenüber einem Abtropfen oder Herausrieseln von Verdampfungsmaterial ist. Die Experimente zeigten, dass das Verdampfungsmaterial nicht in flüssiger Form aus dem ersten Tiegel 10 in den zweiten Tiegel 20 (siehe Figur 1) ausläuft, sondern in der Tiegelwand 11 gehalten wird.

Figur 3E zeigt ein weiteres Beispiel der Erfindung, bei welchem die Tiegelwand 11 aus einem porösen Sintermaterial hergestellt ist. Das Sintermaterial umfasst z.B. annähernd kugelförmige Teilchen, z. B. aus Wolfram, mit typischen Größen im nm- bis pm- Bereich. Die zwischen den Teilchen verbleibenden Zwischenräume bilden die durchgehenden Hohlräume in der Tiegelwand 11. Im Betrieb füllen sich die Zwischenräume mit dem Verdampfungsmaterial, wobei eine Zusammensetzung (Verbundmaterial) aus dem Verdampfungsmaterial und dem Wandmaterial gebildet wird, das sich durch die erhöhte Beständigkeit bei Temperaturwechseln auszeichnet.

Gemäß einer weiteren Variante der Erfindung umfasst die Tiegelwand 11 ein Figur 3F illustriertes Schlitzblech. Die Tiegelwand 11 wird aus einer Metallfolie oder einem Metallblech (Dicke rund 15 µm) geschnitten. Die Schlitze 14 werden mit einer Schneidetechnik, wie z. B. Laser-basiertes Schneiden, in die Tiegelwand 11 eingefügt. Die Schlitze 14 verlaufen in axialer Richtung des Tiegels 10. Bei einer regelmäßigen Anordnung in axial verlaufenden Reihen sind die Schlitze in benachbarten Reihen relativ zueinander versetzt angeordnet. Vorteilhafterweise kann sich ein derart gebildetes Schlitzblech wie Streckmetall verformen. Bei mechanischer Beanspruchung in der Tiegelwand 11 senkrecht zur Schlitzrichtung kann sich die Tiegelwand 11 dreidimensional ausweiten. Das in Figur 3F gezeigte Schlitzblech kann einlagig oder mehrlagig verwendet werden, um die Tiegelwand 11 zu bilden. Bei einer mehrlagigen Anordnung (z. B. gewickelt) sind die Schlitze 14 vorzugsweise in radialer Richtung versetzt angeordnet, so dass Schlitze 14 in einer Lage vom Wandmaterial in der benachbarten Lage abgedeckt werden. Dadurch wird wie im Fall eines mehrlagigen Geflechts der Fluss von Verdampfungsmaterial durch die durchlässige Tiegelwand 11 gebremst. Entsprechend wird damit die ausnutzbare Füllhöhe des Tiegels 10 vergrößert.

Figur 4 zeigt eine weitere Ausführungsform der erfindungsgemäßen Verdampferzelle 100, bei welcher der erste Tiegel 10 aus Drahtgeflecht in den zweiten Tiegel 20 aus massiver, geschlossener Folie eingesetzt ist. Am unteren Ende des ersten Tiegels 10 sind die Ränder der zylindrischen Tiegelwand 11 durch eine mechanische Bearbeitung zusammengefügt, so dass eine Geflechtstütze 15 gebildet wird. Vorteilhafterweise kann der erste Tiegel 10 im zweiten Tiegel 20 durch die Geflechtstütze 15 und durch ein Anlegen der Tiegelwand 11 des ersten Tiegels 10 an der Tiegelwand 21 des zweiten Tiegels 20 stabil gehalten werden. Eine zusätzliche Fixierung des ersten Tiegels 10 im zweiten Tiegel 20 ist nicht erforderlich. Dadurch wird vorteilhafterweise ein Austausch des ersten Tiegels erleichtert.

Figur 5 illustriert schematisch einen ersten Tiegel 10, dessen Tiegelwand 11 durch ein Schlitzblech mit Schlitzen 14 gebildet wird, mit weiteren, kompakten Wandabschnitten. Die Austrittsöffnung 12 umgebend ist eine Tiegellippe 16 vorgesehen. Die Tiegellippe 16 bildet einen in radialer Richtung vorspringenden Kragen, z. B. aus einem Metallblech. Die Tiegellippe 16 kann in ein Metallblech übergehen, das die Austrittsöffnung 12 im obersten Bereich der Seitenwand des ersten Tiegels 10 umgibt. Des Weiteren ist ein Bodentopf 17 vorgesehen, mit welchem der erste Tiegel 10 am unteren Ende abgeschlossen wird. Der Bodentopf 17 umfasst ebenfalls ein massives Material, wie z. B. Metallblech. Mit der Tiegellippe 16 und dem Bodentopf 17 wird die mechanische Stabilität des ersten Tiegels 10 erhöht. Der erste Tiegel 10 kann in den zweiten Tiegel 20 (siehe Figur 1) eingehängt werden, wobei eine Halterung des ersten Tiegels 10 mit der Tiegellippe 16 am oberen Rand des zweiten Tiegels 20 vorgesehen sein kann. In diesem Fall sind in der Tiegellippe 16 Öffnungen 18 vorgesehen, um die Dampfphase des Verdampfungsmaterials aus der Lücke 22 zwischen den Tiegeln 10, 20 austreten zu lassen.

Die in der vorstehenden Beschreibung, den Zeichnungen und den Ansprüchen offenbarten Merkmale der Erfindung können sowohl einzeln als auch in Kombination für die Verwirklichung der Erfindung in ihren verschiedenen Ausgestaltungen von Bedeutung sein.

## Patentansprüche

1. Verdampferzelle (100), umfassend:
- einen ersten Tiegel (10) mit einer Tiegelwand (11), wobei der erste Tiegel (10) zur Aufnahme von Verdampfungsmaterial und zur Verdampfung des Verdampfungsmaterials eingerichtet ist,
**dadurch gekennzeichnet, dass**
- die Tiegelwand (11) durchgehende Hohlräume (14) aufweist.

2. Verdampferzelle gemäß Anspruch 1, mit mindestens einem der Merkmale
- die Hohlräume (14) haben mindestens eine der Formen, die Poren, Risse, Kanäle und Schlitze umfassen,
- die Hohlräume (14) sind regelmäßig verteilt angeordnet,
- die Hohlräume (14) sind unregelmäßig verteilt angeordnet,
- die Tiegelwand (11) ist einlagig gebildet,
- die Tiegelwand (11) ist mehrlagig gebildet, und
- die Hohlräume (14) haben eine charakteristische Dimension derart, dass geschmolzenes Verdampfungsmaterial unter der Wirkung der Oberflächenspannung in den Hohlräumen (14) gehalten wird.

3. Verdampferzelle gemäß Anspruch 2, bei der
- die Hohlräume (14) Schlitze umfassen, die in axialer und/oder radialer Richtung der Tiegelwand (11) relativ zueinander versetzt angeordnet sind.

4. Verdampferzelle gemäß einem der vorhergehenden Ansprüche, bei der
- die Tiegelwand (11) mindestens eines der Wandmaterialien aufweist, die mindestens ein Drahtgeflecht, mindestens eine mit Schlitzen versehene Folie, mindestens ein Sintermaterial und mindestens einen Schaum umfassen.

5. Verdampferzelle gemäß einem der vorhergehenden Ansprüche, die umfasst
- einen zweiten Tiegel (20), in dem der erste Tiegel (10) angeordnet ist, wobei
- zwischen dem ersten Tiegel (10) und dem zweiten Tiegel (20) eine Lücke (22) gebildet ist, aus der gleichzeitig zum Austritt von Verdampfungsmaterial aus dem ersten Tiegel (10) weiteres Verdampfungsmaterial dampfförmig austreten kann.

6. Verdampferzelle gemäß Anspruch 5, bei der
- der erste Tiegel (10) und der zweite Tiegel (20) voneinander lösbar angeordnet sind.

7. Verdampferzelle gemäß einem der vorhergehenden Ansprüche, bei der
- der erste und/oder der zweite Tiegel (10, 20) aus Metall, z. B. Wolfram oder Tantal, oder Keramik, z. B. Bornitrid, hergestellt ist, und/oder
- der erste Tiegel (10) und der zweite Tiegel (20) mindestens eine von einer zylindrischen und einer konischen Form aufweisen.

8. Beschichtungsvorrichtung (200), die mit mindestens einer Verdampferzelle (100) gemäß einem der vorhergehenden Ansprüche ausgestattet ist.

9. Verfahren zur Verdampfung eines Verdampfungsmaterials, wobei eine Verdampferzelle (100) gemäß einem der Ansprüche 1 bis 7 verwendet wird, umfassend die Schritte:
- Bereitstellung des Verdampfungsmaterials in dem ersten Tiegel (10), und
- Heizung des ersten Tiegels (10) auf eine vorbestimmte Betriebstemperatur, so dass eine Dampfphase des Verdampfungsmaterials erzeugt wird,
**dadurch gekennzeichnet, dass**
- die Hohlräume (14) der Tiegelwand (11) bei der Betriebstemperatur mit dem Verdampfungsmaterial gefüllt werden und ein Austritt von Verdampfungsmaterial durch die Hohlräume (14) in die Umgebung des ersten Tiegels (10) mindestens teilweise blockiert wird.

10. Verfahren gemäß Anspruch 9, bei dem
- die Hohlräume (14) in der Tiegelwand (11) bei deren Herstellung oder bei der Verwendung der Verdampferzelle (100) unter der Wirkung des Verdampfungsmaterials geformt werden, und/oder
- die Hohlräume (14) eine derartige charakteristische Dimension haben, dass bei der Betriebstemperatur geschmolzenes Verdampfungsmaterial unter der Wirkung der Oberflächenspannung in den Hohlräumen (14) gehalten wird.

11. Verfahren gemäß Anspruch 9 oder 10, bei dem
- der erste Tiegel (10) in einem zweiten Tiegel (20) angeordnet ist, wobei
- zwischen dem ersten Tiegel (10) und dem zweiten Tiegel (20) eine Lücke (22) gebildet ist, aus der bei der Betriebstemperatur gleichzeitig zum Austritt von Verdampfungsmaterial aus dem ersten Tiegel (10) weiteres Verdampfungsmaterial dampfförmig austritt.
